# EUROPEAN PATENT APPLICATION

(11) **EP 4 458 511 A1**
(43) Date of publication of application: **06.11.2024**
(21) Application number: 22915165.9
(22) Date of filing: 30.12.2022
(51) Int. Cl.: B24B 29/02, H01L 21/304

(54) **WAFER POLISHING SYSTEM AND WAFER TRANSFER METHOD**

(30) Priority: 31.12.2021 CN 202111669414; 22.12.2022 CN 202211653830
(71) Applicant: Hangzhou Sizone Electronic Technology Inc., Hangzhou Zhejiang 311300 (CN)
(72) Inventor: XU, Xiaoyu, Hangzhou, Zhejiang 311300 (CN); DENG, Yaomin, Hangzhou, Zhejiang 311300 (CN)
(74) Representative: Becker, Eberhard
(86) International application number: PCT/CN2022/143854
(87) International publication number: WO 2023/125916

(57) **Abstract**

Disclosed in the present invention is a wafer polishing system, comprising polishing units. Each polishing unit comprises a wafer transfer channel and a polishing module; the polishing module comprises a polishing platform and a polishing arm, and the polishing arm can drive a wafer to move relative to the polishing platform; the wafer transfer channel is provided with at least two work stations, and a wafer loading/unloading table can move between the work stations; a transmission structure is provided between adjacent polishing units, a wafer is transferred between work stations of the adjacent polishing units along a first track, and the first track falls on wafer transfer channels; and/or a wafer loading/unloading table can move between adjacent polishing units; and/or a transfer structure is provided between a polishing unit and an external transition table, a wafer is transferred between work stations of the polishing unit and the external transition table along a second track, and the second track falls on a wafer transfer channel. Further disclosed in the present invention is a wafer transfer method. In the present invention, tracks all fall on wafer transfer channels, so that no other space is occupied, and the layout is reasonable; the process is flexible, and the processing efficiency is high; the transfer stability is high.

## Description

### Technical Field

The invention belongs to the technical field of semiconductor integrated circuit chip manufacturing, and particularly relates to a wafer polishing system and a wafer transfer method. Background

Chemical mechanical polishing planarization equipment usually comprises an equipment front end module (EFEM), cleaning units, polishing units and a transfer module. The EFEM mainly comprises a wafer box, a wafer transfer robotic arm and an air purification system. The cleaning unit mainly comprises megasonic cleaning components, scrubber cleaning components and drying components of different quantities, and devices for transferring wafers between the components. The polishing unit mainly comprises a polishing table, a polishing head, a polishing liquid supply system and a polishing pad dressing system. The transfer module comprises a series of robotic arms or mobile platforms, which send wafers to be polished from the EFEM to the polishing units and transport polished wafers from the polishing units to the cleaning units. In addition to the quantities, relative layout and processes of the polishing units and the cleaning units, the transfer mode and transfer route of a transfer system are also crucial determinants of the overall efficiency of the machine.

In typical chemical mechanical planarization equipment, a polishing module comprises two columns of polishing unit arrays, each column of polishing units comprises a plurality of groups of polishing units, load ports corresponding to the two columns of polishing unit arrays are longitudinally arranged in the column direction of the polishing unit arrays, and a working part of a top transfer device is directly above the load ports, enabling the transfer of wafers between other loading/unloading areas and the load ports, as well as between the load ports. As required, each group of top transfer devices can be arranged in a cascading manner to complete the transfer of wafers between different load ports, enabling the circulation of wafers in the whole polishing unit array.

However, the top transfer device bears a heavy transportation load, and at the same time, due to the specific structure of the polishing module, it is not possible to add any other transfer devices. Therefore, wafers can only be transferred out of polishing units through the top transfer device, resulting in a lack of process flexibility. Moreover, the working part of the top transfer device being directly above the load ports necessitates lowering to the load ports for wafer pickup or placement. This process consumes a significant amount of time, especially when it involves the transfer of wafers between different rows of polishing units in staggered dual-platform and triple-platform processes. The top transfer device is responsible for wafer pickup, placement and transportation, leading to a substantial decrease in wafer transport efficiency. Furthermore, depending solely on the top transfer device for wafer pickup, placement, and transportation accelerates the time of the transfer device and increases the risk of impurities in the wearing process. This transfer method imposes high requirements on the wafer transfer capabilities and stability of the top transfer unit. In the event of a failure in the top transfer unit, wafers cannot be timely transported out of a polishing area, leading to product defects.

### SUMMARY OF THE INVENTION

To overcome the limitations of the prior art, the invention provides a wafer polishing system that offers multiple transfer modes without occupying excessive space, and a wafer transfer method of the wafer polishing system.

The technical scheme adopted by the invention to solve the technical problems is as follows. A wafer polishing system comprises polishing units;
the polishing unit comprises a wafer transfer channel and polishing modules;
the polishing module comprises a polishing platen and a polishing arm, and the polishing arm is able to drive wafers to move relative to the polishing platen to realize a polishing process;
the wafer transfer channel is provided with at least two working positions, and a wafer load port is able to move between the working positions;
a delivery structure is arranged between adjacent polishing units, which transfers wafers between working positions of the adjacent polishing units along a first trajectory, and the first trajectory falls on the wafer transfer channel;
and/or the wafer load port is able to move between adjacent polishing units;
and/or a conveyance structure is arranged between the polishing unit and an external transfer station, which transfers wafers between working positions of the polishing unit and the external transfer station along a second trajectory, and the second trajectory falls on the wafer transfer channel.

Further, the wafer polishing system comprises a top transfer mechanism which transfers wafers between all the polishing units along a third trajectory, and the third trajectory falls on the wafer transfer channel;
alternatively, the top transfer mechanism transfers wafers between any polishing unit and the external transfer station along a fourth trajectory, and the fourth trajectory falls on the wafer transfer channel.

Further, the top transfer mechanism is located above the delivery structure and/or the conveyance structure.

Further, the delivery structure comprises a clamping unit for clamping wafers and a turnover unit, and the turnover unit is used for driving the clamping unit and wafers to turn forward or backward in the wafer transfer channel.

Further, the delivery structure comprises a clamping unit for clamping wafers, a translation unit, and a lifting unit, the translation unit is used for translating the clamping unit and wafers in the wafer transfer channel, and the lifting unit is used for driving the whole delivery structure to rise or fall, in order for the delivery structure to be located below or above the polishing platform.

Further, the delivery structure comprises a base and a telescopic arm connected with the base, and the telescopic arm extends downwards from an area above the polishing platform, or the telescopic arm extends upwards from an area below the polishing platform.

Further, the delivery structure comprises an auxiliary working position between adjacent polishing units, and an auxiliary transfer unit arranged above or below the auxiliary working position, and the wafer load ports of the adjacent polishing units are able to be moved to the auxiliary working position; and the auxiliary transfer unit is used for adsorbing wafers on the auxiliary working position or placing wafers on the wafer load port on the auxiliary working position, and the auxiliary transfer unit is located below or above the polishing platform.

Further, movement paths of the wafer load ports which are capable of moving between adjacent polishing units have overlapping sections, at least partially, and the overlapping paths contain at least one working position.

Further, a gap exists between adjacent polishing units.

Further, a delivery structure is arranged between adjacent working positions of the same polishing unit.

Further, the delivery structure and the conveyance structure are the same.

The invention further discloses a wafer transfer method of a wafer polishing system. The wafer polishing system comprises polishing units, the polishing unit comprises a wafer transfer channel, the wafer transfer channel is provided with at least two working positions, and a wafer load port is able to move between the working positions. The wafer transfer method comprises the following step:
transferring, by a delivery structure, wafers from the working position of one polishing unit to the working position of another adjacent polishing unit along a first trajectory, the first trajectory falling on the wafer transfer channel.

Further, a conveyance structure transfers wafers from the working position of the polishing unit to an external transfer station or from the external transfer station to the working position of the polishing unit along a second trajectory, and the second trajectory falls on the wafer transfer channel.

Further, the wafer transfer method comprises the following steps:
using the delivery structure and the wafer load port to transfer wafers between the working positions of the polishing unit along the first trajectory until wafers enter a target working position, acquiring, by a polishing arm, wafers at the working position, and rotating the polishing arm to a polishing platform for a polishing process;
alternatively, using a top transfer mechanism to transfer wafers between the working positions of the polishing unit along a third trajectory to directly enter the target working position, acquiring, by the polishing arm, wafers at the working position, and rotating the polishing arm to the polishing platform for the polishing process;
alternatively, using the delivery structure, the wafer load port and the top transfer mechanism to transfer wafers between the working positions of the polishing unit along the first trajectory and the third trajectory until wafers enter the target working position, acquiring, by the polishing arm, wafers at the working position, and rotating the polishing arm to the polishing platform for the polishing process;
wherein the first trajectory and the third trajectory both fall on the wafer transfer channel.

Further, the wafer transfer method comprises the following steps:
using a conveyance structure to transfer wafers from an external transfer station to the working position of the polishing unit along a second trajectory;
alternatively, using a top transfer mechanism to transfer from the external transfer station to the working position of the polishing unit along the third trajectory; wherein the second trajectory and the third trajectory both fall on the wafer transfer channel.

Further, the number of the polishing units is more than one, the polishing process is divided into multiple stages, and downstream polishing units are located near a middle of the wafer transfer channel.

The invention has the following merits that: (1) the first trajectory, the second trajectory and the third trajectory all fall within the wafer transfer channel, without occupying any additional space, thereby ensuring a reasonable layout; (2) the conveyance structure, the delivery structure, and top transfer mechanism can be combined for use, thus providing high process flexibility without generating interference; the arrangement of the conveyance structure and the delivery structure will not negatively impact the top transfer mechanism, and the top transfer mechanism can pass through the polishing units any time without any disturbance; and implementing this layout helps to reduce the travel distance of transfer and significantly enhances the processing efficiency of chemical mechanical planarization equipment; (3) it does not increase the risk of impurities related to wear in the transfer process; (4) transfer stability is high, and in case of a malfunction in one transfer device, other transfer devices will enter a working mode, ensuring timely transfer of wafers from a polishing area and guaranteeing the quality of wafer products; and (5) independent wafer transfer channels are built between adjacent wafer storage stations, which can be used separately or in conjunction with the top transfer mechanism, increasing the flexibility of wafer transfer in the polishing area and reducing the transfer pressure of the top transfer device on the top of a wafer holder, thereby enhancing the overall transfer efficiency.

### DESCRIPTION OF THE DRAWINGS

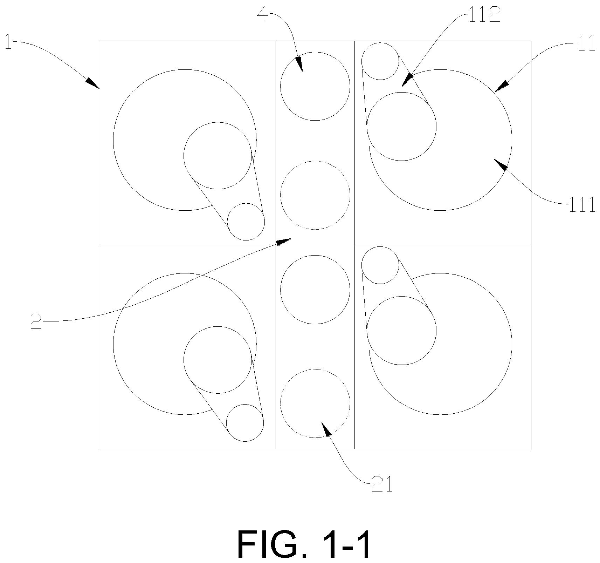

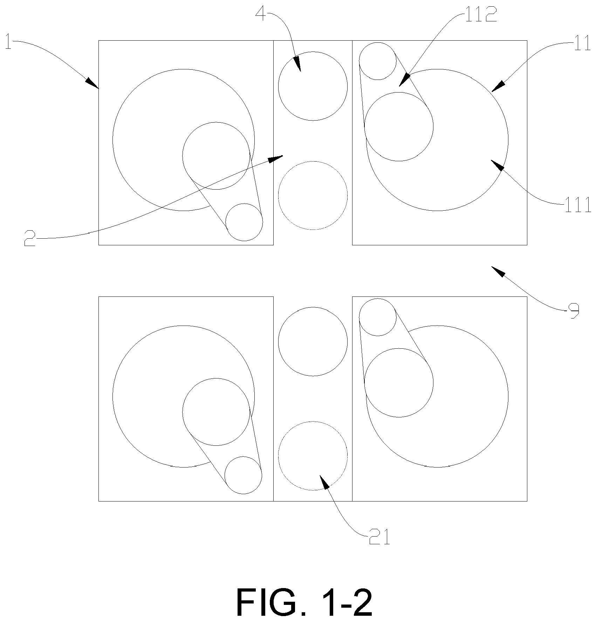

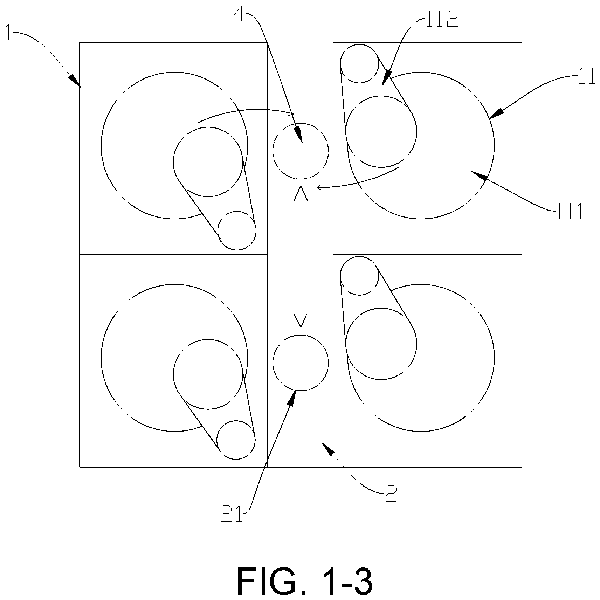

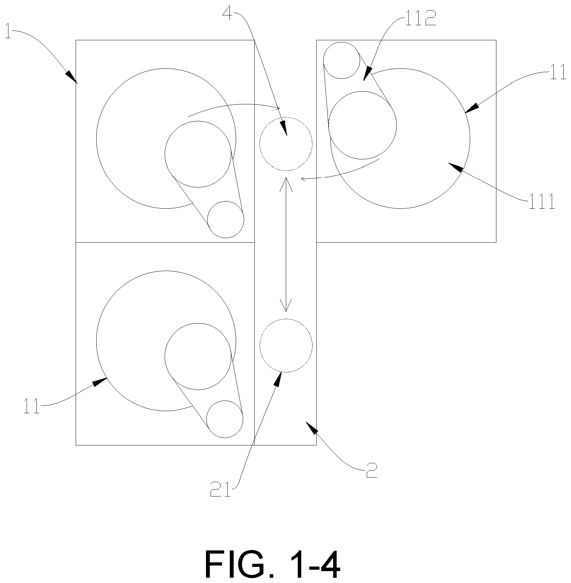

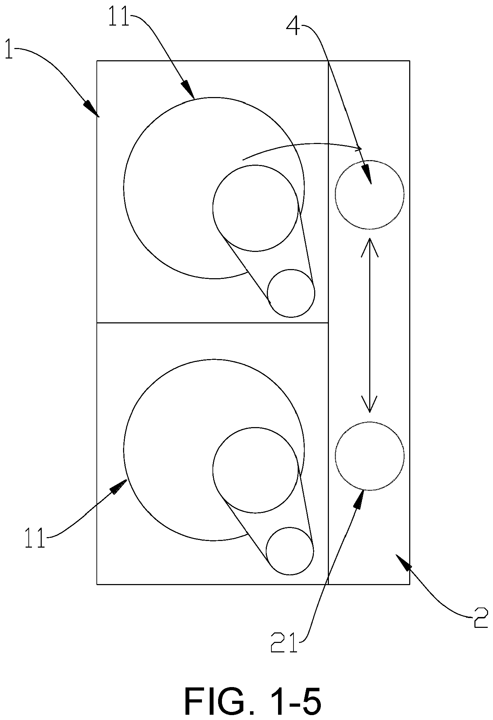

FIG. 1-1 is a schematic diagram of a wafer polishing system according to Embodiment 1 of the invention, which comprises two polishing units.
FIG. 1-2 is a schematic diagram of a wafer polishing system according to Embodiment 1 of the invention, where a gap exists between two polishing units.
FIG. 1-3 is a schematic diagram according to Embodiment 1 of the invention, where a single polishing unit has only one working position.
FIG. 1-4 is a schematic diagram according to Embodiment 1 of the invention, where one polishing unit comprises two polishing modules and the other polishing unit comprises one polishing module.
FIG. 1-5 is a schematic diagram according to Embodiment 1 of the invention, where each polishing unit comprises one polishing module.
FIG. 2 is a schematic diagram of a wafer polishing system according to Embodiment 1 of the invention, where a delivery structure comprises a clamping unit, a translation unit and a lifting unit.
FIG. 3 is a schematic diagram of a wafer polishing system according to Embodiment 1 of the invention, where a delivery structure comprises a base and a telescopic arm.
FIG. 4 is a schematic diagram of a wafer polishing system according to Embodiment 1 of the invention, where a delivery structure comprises an auxiliary working position and an auxiliary transfer unit.
FIG. 5 is a first schematic diagram of a wafer polishing system according to Embodiment 2 of the invention.
FIG. 6 is a second schematic diagram of a wafer polishing system according to Embodiment 2 of the invention.
FIG. 7 is a schematic diagram of a top transfer mechanism according to Embodiment 3 of the invention.
FIG. 8 is a top view of a structure where a top transfer mechanism is in coordination with polishing units according to Embodiment 3 of the invention.
FIG. 9 is a side view of a structure where a top transfer mechanism is in coordination with polishing units according to Embodiment 3 of the invention.
FIG. 10 is a schematic diagram of a wafer polishing system according to Embodiment 4 of the invention.
FIG. 11 is a first schematic diagram of a wafer polishing system according to Embodiment 5 of the invention.
FIG. 12 is a second schematic diagram of a wafer polishing system according to Embodiment 5 of the invention.
FIG. 13 is a third schematic diagram of a wafer polishing system according to Embodiment 5 of the invention.
FIG. 14 is a fourth schematic diagram of a wafer polishing system according to Embodiment 5 of the invention.
FIG. 15 is a schematic diagram of position arrangement of a wafer polishing system according to Embodiment 6 of the invention.

### DETAILED DESCRIPTION OF EMBODIMENTS

For people skilled in the art to better understand the scheme of the invention, the technical scheme in the embodiments of the invention will be clearly and completely described below in combination with attached drawings. Obviously, the described embodiments are only part of the embodiments of the invention, not all of them. Based on the embodiments of the invention, all other embodiments obtained by those of ordinary skill in the art without making creative labor shall belong to the scope of protection of the invention.

### Embodiment 1

A wafer polishing system, comprising polishing units 1:
the polishing unit 1 comprises a wafer transfer channel 2 and polishing modules 11 located on two sides of the wafer transfer channel 2, and the number of the polishing modules 11 is at least two; the polishing module 11 comprises a polishing platform 111 and a polishing arm 112, and the polishing arm 112 is able to drive wafers 3 to move relative to the polishing platform 111 to realize a polishing process of wafers 3;
the wafer transfer channel 2 is provided with at least two working positions 21, and a wafer load port 4 is able to move between the working positions 21; and
a delivery structure 5 is arranged between adjacent polishing units 1, which transfers wafers 3 between working positions 21 of the two polishing units 1 along a first trajectory, and the first trajectory falls on the wafer transfer channel 2.

The wafer transfer channel 2 is not necessarily an exact area, and any space area that the delivery structure 5 can reach can be defined as the wafer transfer channel 2.

As shown in FIG. 1-1, two adjacent polishing units 1 are in close proximity, without any gaps. As shown in FIG. 1-2, a gap 9 can also be provided between two adjacent polishing units 1, which can be used as a channel for conveying wafers to other directions or receiving wafers.

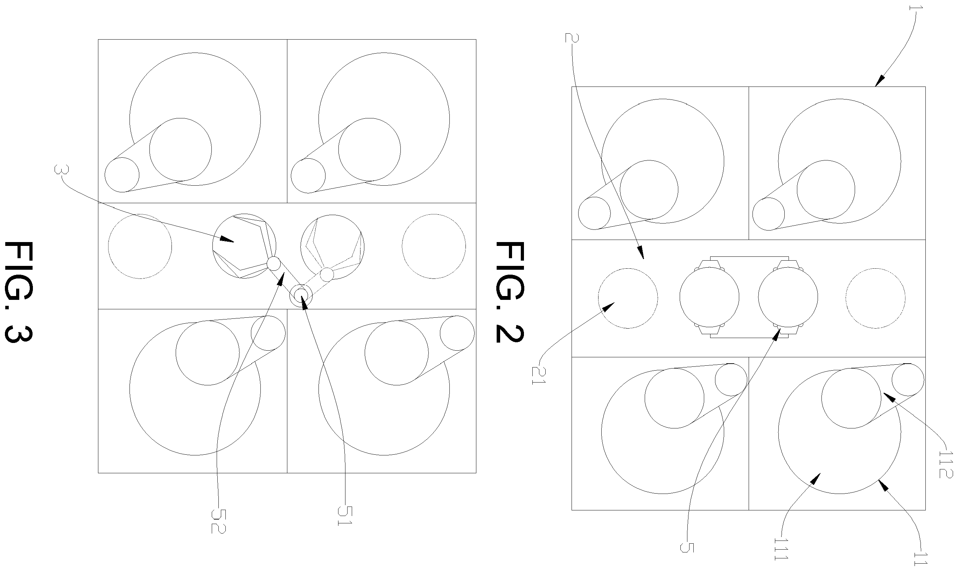

The delivery structure 5 comprises a clamping unit for clamping wafers 3, a translation unit, and a lifting unit, the translation unit is used for translating the clamping unit and wafers in the wafer transfer channel 2, and the lifting unit is used for driving the clamping unit and wafers to rise or fall as a whole, in order for the delivery structure 5 to be located below or above the polishing platform 111, as shown in FIG. 2.

Of course, the delivery structure 5 can also be other structures, such as comprising a base 51 located in the wafer transfer channel 2 and a telescopic arm 52 connected with the base 51, an end of the telescopic arm 52 can hold wafers 3, and the telescopic arm 52 extends downward from an upper area of the polishing platform 111; or the telescopic arm 52 extends upward from a lower area of the polishing platform 111, as shown in FIG. 3.

The telescopic arm 52 may comprise two arm bodies or three arm bodies, and a clamping jaw at the end of the telescopic arm 52 may have a single-jaw structure or a double-jaw structure, which is not limited here.

The delivery structure 5 can also be arranged between two working positions of the same polishing unit 1, the two working positions are provided with wafer load ports respectively, and the wafer load ports can be relatively fixed.

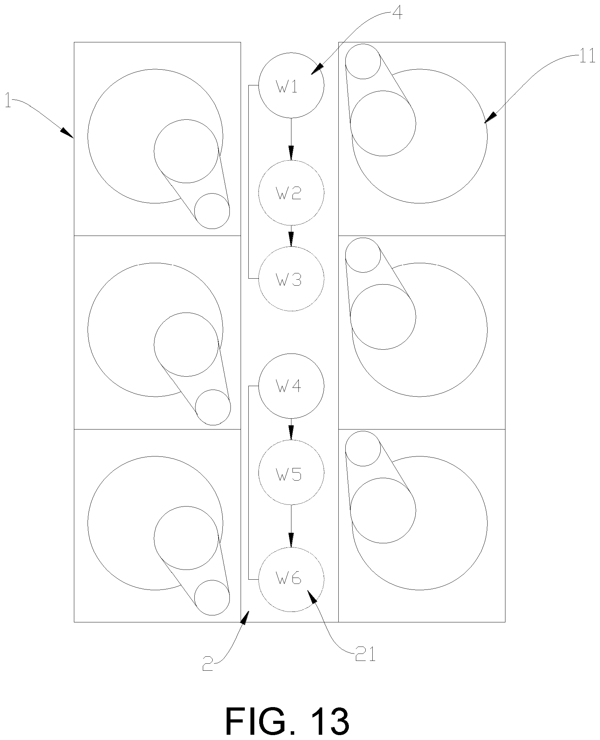

Of course, it is not to say that a polishing unit 1 must have two working positions, it can also have only one working position, and in this case, the delivery structure 5 is between two working positions of two adjacent polishing units, as shown in FIG. 13.

Generally, the polishing unit 1 comprises at least two polishing modules 11, but it is not limited to this, as a polishing unit 1 can also comprise just one polishing module 11. As shown in FIG. 1-4, the upper polishing unit 1 comprises two polishing modules 11, which are located on two sides of the wafer transfer channel 2, and the lower polishing unit 1 comprises one polishing module 11. As shown in FIG. 1-5, the upper polishing unit 1 comprises one polishing module 11, and the lower polishing unit 1 also comprises one polishing module 11.

In addition, the delivery structure 5 may further comprise an auxiliary working position 53 between adjacent polishing units 1, and an auxiliary transfer unit 54 arranged above or below the auxiliary working position 53, and the wafer load ports 4 of the adjacent polishing units 1 are able to be moved to the auxiliary working position 53; the auxiliary transfer unit 54 is used for adsorbing wafers on the auxiliary working position 53, and then keeping the wafers adsorbed until another wafer load port 4 moves to the auxiliary working position 53; alternatively, the auxiliary transfer unit 54 is used to place wafers on the wafer load port 4 at the auxiliary working position 53, that is, when another wafer load port 4 moves to the auxiliary working position 53, the auxiliary transfer unit 54 places the wafers on the wafer load port 4.

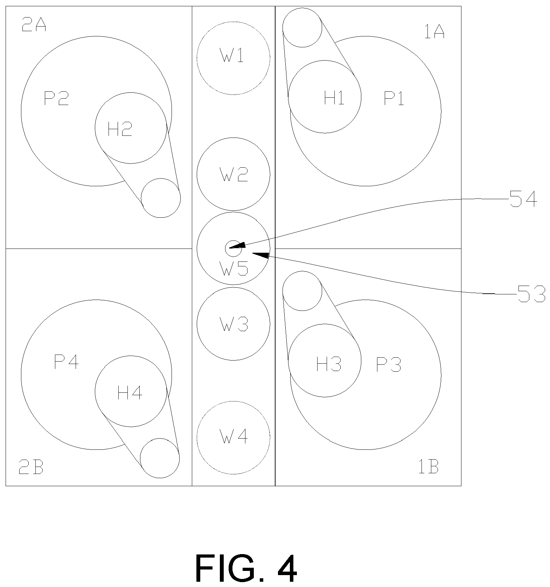

As shown in FIG. 4, an auxiliary working position W5 is added, which is located between the working position W2 and the working position W3 of adjacent polishing units 1, and the wafer load ports 4 on both sides can move to the auxiliary working position W5, that is, the moving range of the wafer load ports 4 covers the working position W1, the working position W2 and the working position W5, as well as the working position W5, the working position W3 and the working position W4. The auxiliary transfer unit 54 is located above the working position W5, and can pick up and place wafers at the working position W5 and indirectly transfer wafers between the working position W2 and the working position W3.

Delivery structures 5 of different structures can coexist, that is, delivery structures 5 of different structures can be used in combination in the same wafer transfer method.

After the polishing process by the polishing module 2A ends, the polishing arm H2 transfers wafers to the working position W2. Next, proceed to Step 1 or Step 2:
In Step 1, the wafers are transferred to the working position W5, the auxiliary transfer unit 54 takes the wafers away from the working position W5, the movable wafer load port 4 at the working position W3 moves to the working position W5, and the auxiliary transfer unit 54 places the wafers at the working position W5 and then transfers the wafers to the working position W3. The polishing arm H3 carries the wafers into the polishing module 1B for polishing.
In Step 2, the wafers are transferred to the working position W5, the auxiliary transfer unit 54 takes the wafers away from the working position W5, the movable wafer load port 4 at the working position W3 moves to the working position W5, and the auxiliary transfer unit 54 places the wafers at the working position W5 and then transfers the wafers to the working position W3. The movable wafer load port 4 conveys the wafers from the working position W3 to the working position W4. The polishing arm H4 carries the wafers into the polishing module 2B for polishing.

Of course, the auxiliary transfer unit 54 can also be located below or above the polishing platform 111, and in this case, the transfer trajectory of wafers 3 is still located on the wafer transfer channel 2.

### Embodiment 2

A conveyance structure 7 is arranged between the polishing unit 1 and an external transfer station 6, which transfers wafers 3 between the polishing unit 1 and the external transfer station 6 along a second trajectory, and the second trajectory falls on the wafer transfer channel 2.

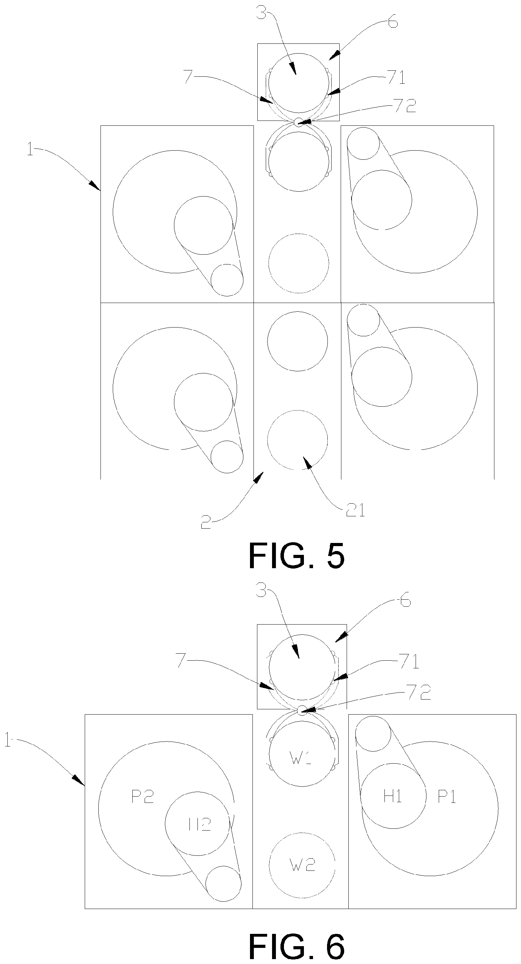

The conveyance structure 7 comprises a clamping unit 71 for clamping wafers 3 and a turnover unit 72, and the turnover unit 72 is used for driving the clamping unit 71 and wafers 3 to turn forward or backward in the wafer transfer channel 2. Here, the forward direction refers to the downward direction in FIG. 5.

Specifically, as shown in FIG. 6, the wafers 3 can be transported to the working position W1 or W2 by the external transfer station 6, and then moved from the working position W1 to the working position W2 or from the working position W2 to the working position W1 by the wafer load port 4.

Of course, the conveyance structure 7 in this embodiment can have the same structure as the delivery structure 5 in Embodiment 1, or different structures can be used in combination. The specific details will not be repeated here.

### Embodiment 3

The structures of Embodiment 1 and Embodiment 2 can exist independently or simultaneously, and can also coexist with a top transfer mechanism 8 in this embodiment. The three can cooperate to transfer wafers.

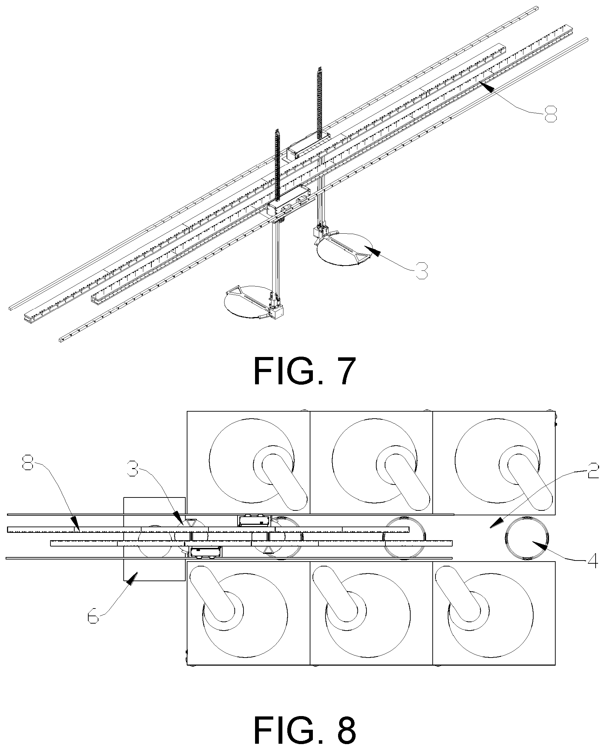

As shown in FIGS. 7-9, the top transfer mechanism 8 transfers wafers 3 between all the polishing units 1 along a third trajectory, and the third trajectory falls on the wafer transfer channel 2.

Of course, the top transfer mechanism 8 can also transfer wafers between any polishing unit 1 and the external transfer station 6 along a fourth trajectory, and the fourth trajectory falls on the wafer transfer channel 2.

The top transfer mechanism 8 is located above the delivery structure 5, or above the conveyance mechanism 7, or above both the delivery structure 5 and the conveyance mechanism 7.

### Embodiment 4

On the basis of Embodiments 1-3, the wafer load port 4 can be moved to the adjacent polishing unit 1.

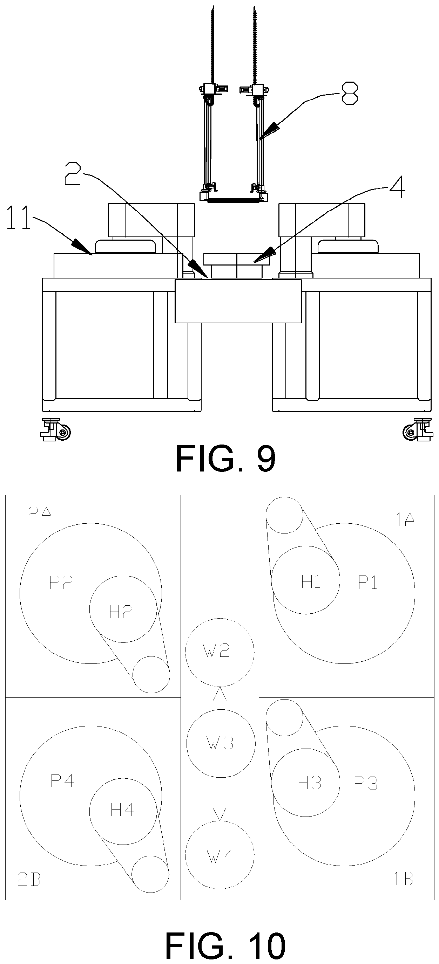

As shown in FIGS. 10, the moving range of the movable wafer load ports 4 covers the working position W2, the working position W3 and the working position W4. After the polishing process by the polishing module 2A ends, the polishing arm H2 transfers wafers to the working position W2. Next, proceed to Step 1 or Step 2:
In Step 1, the movable wafer load port 4 transfers the wafers to the working position W3. The polishing arm H3 carries the wafers into the polishing module 1B for polishing.
In Step 2, the movable wafer load port 4 transfers the wafers to the working position W4. The polishing arm H4 carries the wafers into the polishing module 2B for polishing.

### Embodiment 5

The wafer load port 4 can be moved to the adjacent polishing unit 1, and only two wafer load ports 4 are provided for two or more polishing units 1.

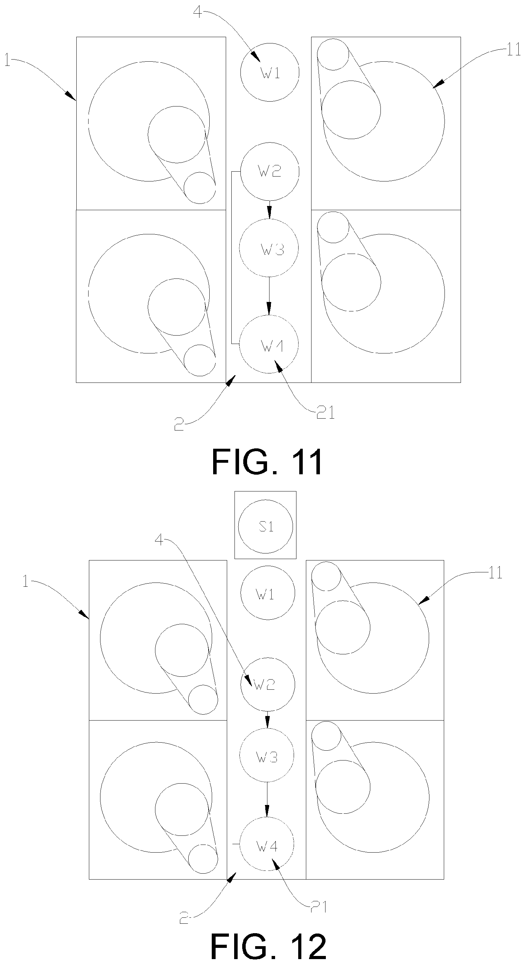

Consider a case where the number of the polishing units 1 is two:
As shown in FIG. 11, one of the wafer load ports 4 is at the working position W1, and the other wafer load port 4 moves between the working position W2, the working position W3 and the working position W4.
Alternatively, as shown in FIG. 12, one of the wafer load ports 4 moves between the working position W1 and the external transfer station S1, and the other wafer load port 4 moves between the working position W2, the working position W3 and the working position W4.

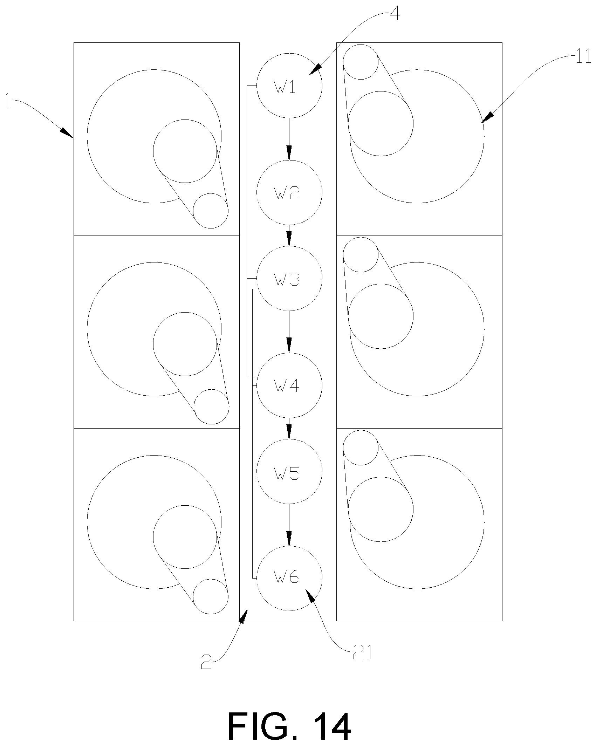

Consider a case where the number of the polishing units 1 is three:
As shown in FIG. 13, one of the wafer load ports 4 moves between the working position W1, the working position W2, and the working position W3, and the other wafer load port 4 moves between the working position W4, the working position W5 and the working position W6.
Movement paths of the wafer load ports 4 which are capable of moving between adj acent polishing units 1 have overlapping sections, at least partially, and the overlapping paths contain at least one working position 21. As shown in FIG. 14, one of the wafer load ports 4 can move to the working position W4 on the basis of moving between the working position W1, the working position W2 and the working position W3, and the other wafer load port 4 can move to the working position W3 on the basis of moving between the working position W4, the working position W5 and the working position W6. In this case, an area between the working position W3 and the working position W4 is the overlapping movement paths of the two wafer load ports 4. The overlapping movement paths contain the working position W3 and the working position W4. **Embodiment 6**

A wafer transfer method of a wafer polishing system is provided. The wafer polishing system comprises polishing units 1, the polishing unit 1 comprises a wafer transfer channel 2, the wafer transfer channel 2 is provided with at least two working positions 21, and a wafer load port 4 is able to move between the working positions 21.

A first wafer transfer method comprises the following step:
a delivery structure 5 arranged between adjacent polishing units 1 transfers wafers 3 between the working positions 21 of the adjacent polishing units 1 along a first trajectory, and the first trajectory falls on the wafer transfer channel 2.

A second wafer transfer method comprises the following step:
a conveyance structure 7 arranged between the polishing unit 1 and an external transfer station 6 transfers wafers 3 between working positions of the polishing unit 1 and the external transfer station 6 along a second trajectory, and the second trajectory falls on the wafer transfer channel 2.

The steps of the above two wafer transfer methods can exist independently or in combination.

A third wafer transfer method comprises the following steps:
using the delivery structure 5 and the wafer load port 4 to transfer wafers 3 between the working positions 21 of the polishing unit 1 along the first trajectory until wafers enter a target working position, acquiring, by a polishing arm 112, the wafers 3 at the working position 21, and rotating the polishing arm to a polishing platform 111 for a polishing process;
alternatively, using a top transfer mechanism 8 to transfer wafers 3 between the working positions 21 of the polishing unit 1 along a third trajectory to directly enter the target working position, acquiring, by the polishing arm 112, the wafers 3 at the working position 21, and rotating the polishing arm to the polishing platform 111 for the polishing process;
alternatively, using the delivery structure 5, the wafer load port 4 and the top transfer mechanism 8 to transfer wafers 3 between the working positions 21 of the polishing unit 1 along the first trajectory and the third trajectory until wafers enter the target working position, acquiring, by the polishing arm 112, the wafers 3 at the working position 21, and rotating the polishing arm to the polishing platform 111 for the polishing process;
wherein the first trajectory and the third trajectory both fall on the wafer transfer channel 2.

A fourth wafer transfer method comprises the following steps:
on the basis of the third wafer transfer method, using a conveyance structure 5 to transfer wafers 3 from an external transfer station 6 to the working position 21 of the polishing unit 1 along a second trajectory;
alternatively, using a top transfer mechanism to transfer from the external transfer station 6 to the working position 21 of the polishing unit 1 along the third trajectory;
wherein the second trajectory and the third trajectory both fall on the wafer transfer channel 2.

For the fourth wafer transfer method, when the number of the polishing units 1 is more than one and the polishing process is divided into multiple stages, downstream polishing units 1 are located near a middle of the wafer transfer channel 2.

In this wafer polishing system, the top transfer mechanism and the mechanism consisting of the delivery structure and the conveyance structure can be applied to the input or output of wafers exclusively, and can also participate in both input and output according to the transfer schedule.
(1) The top transfer mechanism and the mechanism consisting of the delivery structure and the conveyance structure being exclusively used for wafer input or output can be understood as follows: one of the top transfer mechanism and the mechanism consisting of the delivery structure and the conveyance structure exclusively handles wafer input, while the other exclusively handles wafer output.
(2) The top transfer mechanism and the mechanism consisting of the delivery structure and the conveyance structure being applied to both wafer input and wafer output can be understood as follows: the two transfer mechanisms can participate in both wafer input and wafer output according to different processes, thus realizing flexible scheduling of wafer transfer.

General wafer polishing processes are categorized into single-platform, dual-platform and triple-platform processes according to the number of polishing modules 11 used.

As shown in FIG. 14, the external transfer station 6 is denoted by S1, the working positions 21 are denoted by W1, W2, W3, W4, W5 and W6, the polishing platforms 111 are denoted by P1, P2, P3, P4, P5 and P6, and the polishing arms 112 are denoted by H1, H2, H3, H4, H5 and H6.

Taking the single-platform process as an example:

### (1) Remote transfer

In the single-platform process, only one out of six polishing modules 11 (2, 3, 4, 5, or more) is used for planarization. After entering the external transfer station S1 through an EFEM, wafers can be transferred to remote stations (away from the external transfer station 6) using the top transfer mechanisms 8 on two sides. For instance, wafers can be transferred to working positions W5, W6 (and even further Wi, Wi+1, where i ≧ 7). Wafers on the farthest working position W6 can be directly loaded onto the polishing platform P6 by the polishing arm H6, or wafers on the working position W5 can be loaded onto the polishing platform P5 by the polishing arm H5.

### (2) Remote transfer

Wafers on the polishing platforms P1 and P2, located near the external transfer station 6, can be successively transferred and acquired from the external transfer station S1 through either the delivery structure 5 or the conveyance structure 7 in Embodiment 1 and Embodiment 2. After being transferred to the working position W1, wafers can be loaded and transferred to the polishing platform P1 by the polishing arm H1, or translated from the working position W1 to the working position W2 and then loaded and transferred to the polishing platform P2 by the polishing arm H2.

### (3) Middle polishing unit transfer

Two wafers on the middle polishing units, such as P3 and P4 (Pn, where n<i), can be directly input by the top transfer mechanism 8, or can be transferred using different transfer structures in combination.

Wafers on the polishing platform P3 can be transferred from the external transfer station S1 to the working position W1 via the delivery structure 5 or the conveyance structure 7 in Embodiment 1 and Embodiment 2, then translated from the working position W1 to the working position W2, and subsequently input to the working position W3 through the delivery structure 5 in Embodiment 1.

When there is congestion in the delivery structure 5 or the conveyance structure 7, wafers on the external transfer station S1 can also be directly transferred to the working position W2 by the top transfer mechanism 8, then delivered to the working position W3 through the delivery structure 5, and finally loaded and transferred to the polishing platform P3 by the polishing arm H3. Wafers on the polishing platform P4 can be transferred to the working position W4 by the top transfer mechanism 8, and then loaded and transferred to the polishing platform P4 by the polishing arm H4. Alternatively, wafers on the polishing platform P4 can also be translated to the working position W4 after being transferred to the working position W3, and then loaded and transferred to the polishing platform P4 by the polishing arm H4.

Wafer output also follows the principle that priority is given to the top transfer mechanism 8 for remote transfer. Wafers on remote platforms such as the polishing platforms P5, P6 (and even further platforms Pi, Pi+1, where i≥7) are unloaded by the polishing arms H5, H6 (and Hi, Hi+1, where i≥7) to the working positions W5, W6 (and even further positions Wi, Wi+1, where i≥7), and then transferred to the external transfer station S1 by the top transfer mechanism 8 and returned to a wafer box through the EFEM.

Wafers on the near-side platform P1 are unloaded by the polishing arm H1 to the working position W1, and then transferred to S1 by either the delivery structure 5 or the conveyance structure 7. Wafers on the platform P2 are unloaded to the working position W2, then translated to the working position W1, and transferred to S 1 via the delivery structure 5 or the conveyance structure 7. The wafers transferred from the platforms P1 and P2 to the external transfer station S1 are sequentially returned to the wafer box through the EFEM.

Polishing platforms P3, P4 (and Pn, where n<i) are located in the middle. Wafers on the polishing platform P3 are transferred by the polishing arm H3 to the working position W3, then transferred to the working position W2 through the delivery structure 5, then translated to the working position W1, and finally returned to S1 via either the delivery structure 5 or the conveyance structure 7. Wafers on P4 are unloaded by the polishing arm H4 to the working position W4, and then transferred to S1 through the top transfer mechanism. Alternatively, the wafers on P4 can be unloaded to the working position W4 by the polishing arm H4, translated to the working position W3, transferred to the working position W2 via the delivery structure 5, translated to the working position W1, and then returned to S1 via either the delivery structure 5 or the conveyance structure 7. The wafers transferred from P3, P4 (and Pn, where n<i) to S1 are sequentially returned to the wafer box through the EFEM.

### Embodiment 6

Taking the dual-platform process as an example:
There are various arrangements for a dual-platform system, primarily divided into two categories: parallel platform configuration with three sets of dual platforms, and staggered dual-platform configuration. In the original structure, inter-row transfer can only be achieved through the top transfer mechanism 8. If a polishing module in one row, such as the polishing platform P5, fails, or in the case of staggered polishing unit configuration, such as a P5-P4 dual-platform process, wafers that have completed a first polishing process on the polishing platform P5 can be unloaded at the working position W5 and then clamped by the top transfer mechanism 8 to a higher position, before being transferred to a vertical high position of the loading position W4 corresponding to the polishing platform P4. They are then lowered to W4 and subsequently loaded onto the polishing platform P4 by the polishing arm H4 to complete a second polishing process.

By applying the transfer method of the invention, wafers unloaded from the working position W5 can be quickly transferred to the working position W4 by the delivery structure 5 and loaded by the polishing arm H4 to complete the second polishing process. It is clear that the application of the transfer method of the invention significantly reduces the transfer time of wafers between two polishing processes and decreases the risk of introducing defects during multiple-step transfer contact. Staggered transfer also reduces the risk of dead wafers caused by congestion in the case of local failures.

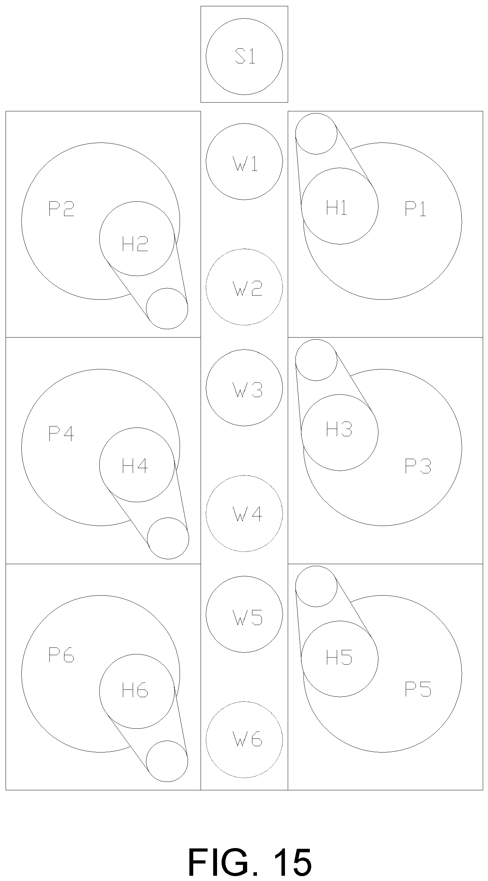

This implementation case takes the parallel dual-platform transfer process with the highest efficiency (minimal inter-platform transfer) as an example, specifically P1-P2 group, P3-P4 group, and P5-P6 group (Pi-Pi+1 group, where i ≧ 7), to outline the transfer scheduling. Refer to FIG. 15.

### (1) Remote transfer

For the remote group P5-P6 (Pi-Pi+1, where i ≧ 7), after being transferred by the top transfer mechanism 8 to the external transfer station S1 through the EFEM, wafers are transferred to the working position W5, then loaded by the polishing arm H5 onto the polishing platform P5 to complete the first stage (completing the first polishing process) of the planarization process. Then the wafers are unloaded by the polishing arm H5 to the working position W5 and translated to the working position W6, and then loaded by the polishing arm H6 onto the polishing platform P6 to complete the second stage (completing the second polishing process) of the planarization process. Finally, the wafers are transferred by the polishing arm H6 to the working position W6 and then to S1 by the top transfer device.

### (2) Near-side transfer

For the near-side group P1-P2, wafers are transferred from S1 to the working position W1 by either the delivery structure 5 or the conveyance structure 7, then loaded onto the polishing platform P1 by the polishing arm H1 to complete the first stage of planarization, and then transferred and unloaded to the working position W1 by the polishing arm H1 before being translated to the working position W2 to complete the second stage of planarization. Then, the wafers are transferred and unloaded to the working position W2 by the polishing arm H2, then translated to the working position W1, and finally transferred to the external transfer station S1 via the delivery structure 5 or the conveyance structure 7. During the transfer process, the transfer mode from the working position W2 to the external transfer station S1 can be adjusted accordingly based on the congestion level of the top transfer device and the transfer structures.

### (3) Middle polishing unit transfer

For middle platform groups P3-P4 (and Pn-Pn+1, where n is odd and n<i), there are various methods for wafers to enter the working position W3 (and Wn, where n is odd and 1<n<i) of the middle transfer platform. One method is to directly input the wafers into the working position W3 using the top transfer mechanism 8 from S1. Another method is to transfer the wafers to the working position W1 via the delivery structure 5 or the conveyance structure 7, then translate them to the working position W2, and then transfer them to the working position W3 using the delivery structure 5. Another method is to directly input the wafers into the working position W2 using the top transfer mechanism 8 from the external transfer station S 1, and then transfer them to the working position W3 using the delivery structure 5. Yet another method is to directly input the wafers into the working position W5 using the top transfer mechanism 8 from the external transfer station S 1, then transfer them to the working position W4 using the delivery structure 5, and finally translate them to the working position W3.

Obviously, the first and second transfer paths only utilize one of the two transfer devices, making them more direct compared to the latter two paths. The wafers at the working position W3 are loaded and transferred to the polishing platform P3 by the polishing arm H3 for the first stage of planarization, then transferred and unloaded to the working position W3, and then translated to the working position W4 before being loaded onto the polishing platform P4 by the polishing arm H4 to complete the second stage of planarization. After that, the wafers are transferred to the working position W4 for unloading. After being unloaded, the wafers can follow the above input path to return. Here, we only describe two ways of output corresponding to the first two input methods. In one way, the wafers are directly transferred from the working position W4 to the external transfer station S 1 by the top transfer mechanism. In the other way, the wafers are translated from the working position W4 to the working position W3, transferred to the working position W2 via the delivery structure 5, translated to the working position W1, and then transferred to the external transfer station S 1 by either the delivery structure 5 or the conveyance structure 7, or by a combination of the top transfer mechanism 8 and the delivery structure 5.

### Embodiment 7

Taking the triple-platform process as an example:
There are various possible configurations for the triple-platform process, and the choice of the polishing unit for the third stage (completing a third polishing process) of planarization partially determines the transfer efficiency. The third stage of planarization can be performed on the near-side platforms (P1, P2) or on the middle platforms (P3, P4, and Pn, where 3<n<i). Take the example of a six-platform system, with the middle platforms chosen for the third stage of planarization, P1-P2-P3 as a near-side group, and P6-P5-P4 as a remote group.

### (1) Remote transfer

For the remote group, after being transferred from the external transfer station S1 to the working position W6 by the top transfer mechanism 8, wafers are loaded onto the polishing platform P6 by the polishing arm H6 to complete the first stage of planarization. Afterwards, the wafers are transferred and unloaded to the working position W6 by the polishing arm H6, then translated to the working position W5, then loaded onto the polishing platform P5 by the polishing arm H5 to complete the second stage of planarization. After that, the wafers are transferred to the working position W4 by the delivery structure 5, and loaded and transferred to the polishing platform P4 by the polishing arm H4 to complete the third stage of planarization. Then the wafers are transferred by the polishing arm H4 and unloaded at the working position W4. After that, the wafers can be directly transferred to the external transfer station S1 through the top transfer mechanism 8, and then returned to the wafer box through the EFEM. Alternatively, the wafers can be translated from the working position W4 to the working position W3, then transferred to the working position W2 by the delivery structure 5, further translated to the working position W1, and then transferred to the external transfer station S1 by the delivery structure 5 or the conveyance structure 7, or by a combination of the top transfer device and the delivery structure 5.

### (2) Near-side transfer

For the near-side group, there are two ways to enter the working position W1. One is to directly input from the external transfer station S1 to the working position W1 through the top transfer mechanism 8 at the right end. Wafers can also be input to the working position W1 through the delivery structure 5 or the conveyance structure 7. Wafers located on W1 are loaded and transferred to the polishing platform P1 by the polishing arm H1 to complete the first stage of planarization. Then, the wafers are transferred to the working position W1 by the polishing arm H1 to be unloaded, then translated to W2, and then loaded and transferred to the polishing platform P2 by the polishing arm H2 to complete the second stage of planarization. Then the wafers are transferred to the working position W2 by the polishing arm H2 to be unloaded, then transferred via the delivery structure 5 to the working position W3, and loaded and transferred to the polishing platform P3 by the polishing arm H3 to complete the third stage of planarization. The wafers are then transferred to the working position W3 to be unloaded. The wafers at the working position W3 can be output in two ways. One is to directly return to S 1 through the top transfer mechanism 8 at the right side. The other is to be transferred via the delivery structure 5 to the working position W2, then translated to the working position W1, then transferred to the external transfer station S 1 by the delivery structure 5 or the conveyance structure 7, and ultimately returned to the wafer box through the EFEM, or output by a combination of the top transfer device and the delivery structure 5.

In a case where the total number of the polishing modules 11 exceeds 6, it is preferable to perform the third stage of planarization on the middle platforms, in order to ensure efficient scheduling of the top transfer mechanism 8 and the delivery structure 5.

The above specific embodiments are used to explain the invention, but not to limit it. Any modification and change made to the invention within the spirit of the invention and the scope of protection of the claims of the invention fall within the scope of the invention.

## Claims

1. A wafer polishing system, comprising polishing units;
wherein the polishing unit comprises a wafer transfer channel and polishing modules;
the polishing module comprises a polishing platform and a polishing arm, and the polishing arm is able to drive wafers to move relative to the polishing platform to realize a polishing process;
the wafer transfer channel is provided with at least two working positions, and a wafer load port is able to move between the working positions;
it is **characterized in that**: a delivery structure is arranged between adjacent polishing units, which transfers the wafers between working positions of the adjacent polishing units along a first trajectory, and the first trajectory falls on the wafer transfer channel;
and/or the wafer load port is able to move between the adjacent polishing units;
and/or a conveyance structure is arranged between the polishing unit and an external transfer station, which transfers the wafers between working positions of the polishing unit and the external transfer station along a second trajectory, and the second trajectory falls on the wafer transfer channel.

2. The wafer polishing system according to Claim 1, **characterized in that**: further comprising a top transfer mechanism which transfers the wafers between all the polishing units along a third trajectory, and the third trajectory falls on the wafer transfer channel;
alternatively, the top transfer mechanism transfers the wafers between any polishing unit and the external transfer station along a fourth trajectory, and the fourth trajectory falls on the wafer transfer channel.

3. The wafer polishing system according to Claim 2, **characterized in that**: the top transfer mechanism is located above the delivery structure and/or the conveyance structure.

4. The wafer polishing system according to Claim 1, **characterized in that**: the delivery structure comprises a clamping unit for clamping the wafers and a turnover unit, and the turnover unit is used for driving the clamping unit and the wafers to turn forward or backward in the wafer transfer channel.

5. The wafer polishing system according to Claim 1, **characterized in that**: the delivery structure comprises a clamping unit for clamping the wafers, a translation unit, and a lifting unit, the translation unit is used for translating the clamping unit and the wafers in the wafer transfer channel, and the lifting unit is used for driving the whole delivery structure to rise or fall, in order for the delivery structure to be located below or above the polishing platform.

6. The wafer polishing system according to Claim 1, **characterized in that**: the delivery structure comprises a base and a telescopic arm connected with the base, and the telescopic arm extends downwards from an area above the polishing platform, or the telescopic arm extends upwards from an area below the polishing platform.

7. The wafer polishing system according to Claim 1, **characterized in that**: the delivery structure comprises an auxiliary working position between the adjacent polishing units, and an auxiliary transfer unit arranged above or below the auxiliary working position, and the wafer load ports of the adjacent polishing units are able to be moved to the auxiliary working position; and the auxiliary transfer unit is used for adsorbing the wafers on the auxiliary working position or placing the wafers on the wafer load port on the auxiliary working position, and the auxiliary transfer unit is located below or above the polishing platform.

8. The wafer polishing system according to Claim 1, **characterized in that**: movement paths of the wafer load ports which are capable of moving between the adjacent polishing units have overlapping sections, at least partially, and the overlapping paths contain at least one working position.

9. The wafer polishing system according to Claim 1, **characterized in that**: a gap exists between the adjacent polishing units.

10. The wafer polishing system according to Claim 1, **characterized in that**: a delivery structure is arranged between adjacent working positions of the same polishing unit.

11. The wafer polishing system according to Claim 1, **characterized in that**: the delivery structure and the conveyance structure are the same.

12. A wafer transfer method of a wafer polishing system, wherein the wafer polishing system comprises polishing units, the polishing unit comprises a wafer transfer channel, the wafer transfer channel is provided with at least two working positions, and a wafer load port is able to move between the working positions; it is **characterized in that**: the wafer transfer method comprises the following step:
transferring, by a delivery structure, wafers from the working position of one polishing unit to the working position of another adjacent polishing unit along a first trajectory, the first trajectory falling on the wafer transfer channel.

13. The wafer transfer method of the wafer polishing system according to Claim 12, **characterized in that**: comprising the following step: transferring, by a conveyance structure, the wafers from the working position of the polishing unit to an external transfer station or from the external transfer station to the working position of the polishing unit along a second trajectory, the second trajectory falling on the wafer transfer channel.

14. The wafer transfer method of the wafer polishing system according to Claim 12, **characterized in that**: comprising the following steps:
using the delivery structure and the wafer load port to transfer the wafers between the working positions of the polishing unit along the first trajectory until the wafers enter a target working position, acquiring, by a polishing arm, the wafers at the working position, and rotating the polishing arm to a polishing platform for a polishing process;
alternatively, using a top transfer mechanism to transfer the wafers between the working positions of the polishing unit along a third trajectory to directly enter the target working position, acquiring, by the polishing arm, the wafers at the working position, and rotating the polishing arm to the polishing platform for the polishing process;
alternatively, using the delivery structure, the wafer load port and the top transfer mechanism to transfer the wafers between the working positions of the polishing unit along the first trajectory and the third trajectory until the wafers enter the target working position, acquiring, by the polishing arm, the wafers at the working position, and rotating the polishing arm to the polishing platform for the polishing process;
wherein the first trajectory and the third trajectory both fall on the wafer transfer channel.

15. The wafer transfer method of the wafer polishing system according to Claim 14, **characterized in that**: comprising the following steps:
using a conveyance structure to transfer the wafers from an external transfer station to the working position of the polishing unit along a second trajectory;
alternatively, using a top transfer mechanism to transfer from the external transfer station to the working position of the polishing unit along the third trajectory;
wherein the second trajectory and the third trajectory both fall on the wafer transfer channel.

16. The wafer transfer method of the wafer polishing system according to Claim 14, **characterized in that**: the number of the polishing units is more than one, the polishing process is divided into multiple stages, and downstream polishing units are located near a middle of the wafer transfer channel.
